# EUROPEAN PATENT APPLICATION

(11) **EP 4 723 819 A1**
(43) Date of publication of application: **08.04.2026**
(21) Application number: 24842174.5
(22) Date of filing: 28.06.2024
(51) Int. Cl.: H05K 7/20, G06F 1/20

(54) **THERMAL MANAGEMENT METHOD, SYSTEM AND APPARATUS FOR VEHICLE, ELECTRONIC DEVICE, AND VEHICLE**

(30) Priority: 14.07.2023 CN 202310869215
(71) Applicant: Great Wall Motor Company Limited, Baoding, Hebei 071000 (CN)
(72) Inventor: LI, Bingtao, Baoding, Hebei 071000 (CN); YANG, Meiling, Baoding, Hebei 071000 (CN)
(74) Representative: Klunker IP Patentanwälte PartG mbB
(86) International application number: PCT/CN2024/102196
(87) International publication number: WO 2025/016178

(57) **Abstract**

The present application provides a thermal management method, a system, and apparatus for a vehicle, an electronic device, and a vehicle. The method includes: controlling, based on pre-received temperature data, a cooling device to cool an intelligent drive domain controller by a vehicle control unit when a cooling request is received. The temperature data is sent by the intelligent driving domain controller via an application message before a vehicle enters a quiescent state, and in this case, a controller local area network bus of the vehicle does not include a private controller area network bus. The cooling request is generated and sent by a head unit system during an upgrade of the intelligent driving domain controller via over-the-air technology. In addition, according to the thermal management method for the vehicle provided by the present application, cooling on the intelligent driving domain controller may be achieved without arranging a private controller area network bus, thereby meeting a cooling requirement of the intelligent driving domain controller while reducing a cost for installation of the private controller area network bus.

## Description

### CROSS-REFERENCE TO RELATED APPLICATIONS

The present disclosure claims priority to Chinese patent application No. 2023108692156 filed on July 14, 2023. All of the aforementioned patent applications are hereby incorporated by reference in their entireties.

### TECHNICAL FIELD

The present application relates to the field of vehicle technologies, and in particular, to a thermal management method, a system, and apparatus for a vehicle, an electronic device, and a vehicle.

### BACKGROUND

With a development of intelligent vehicles and a trend of automotive electronic and electrical architecture evolving from distributed to centralized, a domain controller, serving as a "brain" of future intelligent vehicles, realizes its functions through collaboration of a main control chip, system software, and application algorithms. Currently, during an upgrade of an intelligent driving domain controller via over-the-air (OTA) technology, a cooling device is unable to dissipate heat from the intelligent driving domain controller because the entire vehicle is in a silent state. Therefore, there is an urgent need for a cooling method meeting a cooling requirement of the intelligent driving domain controller during its upgrade.

### SUMMARY

In view of this, an objective of the present application is to provide a thermal management method, a system, and device for a vehicle, an electronic device, and a vehicle, to solve a problem of inability to dissipate heat during an upgrade of an intelligent driving domain controller.

Based on the above objective, a first aspect of the present application provides a thermal management method for a vehicle, applied to a vehicle control unit. A controller area network bus of the vehicle does not include a private controller area network bus. The method includes: controlling, based on pre-received temperature data, a cooling device to cool an intelligent driving domain controller when a cooling request sent by a head unit system during an upgrade of the intelligent driving domain controller via over-the-air technology is received, where the temperature data is sent by the intelligent driving domain controller via an application message before the vehicle enters a silent state.

Optionally, the temperature data includes a current temperature of the intelligent driving domain controller and an inlet temperature of a cooling loop for cooling the intelligent driving domain controller. The cooling device includes a fan, and a water pump of the cooling loop. The controlling, based on pre-received temperature data, a cooling device to cool an intelligent driving domain controller, includes: determining, based on the current temperature and the inlet temperature of the cooling loop, an opening degree of the fan and an opening degree of the water pump according to a pre-established calibration table, where the calibration table is used to characterize a correspondence relationship between the current temperature, the inlet temperature of the cooling loop, the opening degree of the fan, and the opening degree of the water pump; and controlling, based on the opening degree of the water pump and the opening degree of the fan, the water pump and the fan to cool the intelligent driving domain controller, respectively.

Optionally, the method further includes: controlling the cooling device to stop cooling the intelligent driving domain controller when a cooling end request is not received within a first preset duration, where the cooling end request is forwarded by the head unit system using a diagnostic message via a gateway connected to the head unit system after the upgrade of the intelligent driving domain controller is completed. A second aspect of the present application provides a thermal management method for a vehicle, applied to an intelligent driving domain controller. A controller area network bus of the vehicle does not include a private controller area network bus. The method includes: sending temperature data to a vehicle control unit via an application message before the vehicle enters a silent state, enabling the vehicle control unit to control, based on the temperature data, a cooling device to cool the intelligent driving domain controller upon receiving a cooling request, where the cooling request is generated and sent by a head unit system during an upgrade of the intelligent driving domain controller via over-the-air technology.

Optionally, the method further includes: canceling creation of an intelligent driving process when components of the vehicle other than the intelligent driving domain controller are upgraded via the over-the-air technology.

Optionally, the method further includes: controlling a system-on-chip of the intelligent driving domain controller to shut down via a micro-controller unit when an Advanced Driver-Assistance System function is activated, and a temperature of the intelligent driving domain controller exceeds a preset temperature threshold for a preset period and remains above the preset temperature threshold for a third preset duration; controlling the system-on-chip of the intelligent driving domain controller to shut down via the micro-controller unit when the Advanced Driver-Assistance System function is not activated, and the temperature of the intelligent driving domain controller exceeds the preset temperature threshold for the preset period.

A third aspect of the present application provides a thermal management method for a vehicle, applied to a head unit system. A controller area network bus of the vehicle does not include a private controller area network bus. The method includes: generating a cooling request during an upgrade of an intelligent driving domain controller via over-the-air technology; and sending the cooling request via a diagnostic message to a gateway connected to the head unit system, enabling the gateway to send the cooling request to the vehicle control unit and then enabling the vehicle control unit to control, based on pre-received temperature data, a cooling device to cool the intelligent driving domain controller, where the temperature data is sent by the intelligent driving domain controller using an application message before the vehicle enters a silent state.

Optionally, the method further includes: resending the cooling request to the vehicle control unit when the gateway receives a cooling failure signal or fails to receive a feedback signal from the vehicle control unit for a fourth preset duration; where the cooling failure signal is sent by the vehicle control unit to the gateway when cooling of the intelligent driving domain controller fails; and terminating the upgrade of the intelligent driving domain controller after resending the cooling request to the vehicle control unit and the cooling of the intelligent driving domain controller fails.

A fourth aspect of the present application provides a thermal management system for a vehicle, where a controller area network bus of the vehicle does not include a private controller area network bus, and the system includes: a head unit system, configured to generate a cooling request and send the cooling request to a vehicle control unit via a diagnostic message during an upgrade of an intelligent driving domain controller via over-the-air technology; a vehicle control unit, configured to control a cooling device to cool, based on pre-received temperature data, the intelligent driving domain controller when receiving the cooling request; an intelligent driving domain controller, configured to send the temperature data to the vehicle control unit via an application message before the vehicle enters a silent state; and a cooling device, configured to cool the intelligent driving domain controller.

A fifth aspect of the present application provides a thermal management device for a vehicle, applied to a vehicle control unit. A controller area network bus of the vehicle does not include a private controller area network bus. The device includes: a processor, where the processor is configured to execute a program module stored in a memory as follows: a cooling module, configured to control, based on pre-received temperature data, a cooling device to cool the intelligent driving domain controller when a cooling request sent by a head unit system during an upgrade of an intelligent driving domain controller via over-the-air technology is received, where the temperature data is sent by the intelligent driving domain controller via an application message before the vehicle enters a silent state.

A sixth aspect of the present application provides a thermal management device for a vehicle applied to an intelligent driving domain controller. A controller area network bus of the vehicle does not include a private controller area network bus. The device includes: a processor, where the processor is configured to execute a program module stored in a memory as follows: a sending module, configured to send temperature data to a vehicle control unit via an application message before the vehicle enters a silent state, enabling the vehicle control unit to control, based on the temperature data, a cooling device to cool the intelligent driving domain controller upon receiving a cooling request, where the cooling request is generated and sent by a head unit system during an upgrade of the intelligent driving domain controller via over-the-air technology.

A seventh aspect of the present application provides a thermal management device for a vehicle. A controller area network bus of the vehicle does not include a private controller area network bus. The device includes: a processor, where the processor is configured to execute a program module stored in a memory as follows: a generating module, configured to generate a cooling request during an upgrade of an intelligent driving domain controller via over-the-air technology and send the cooling request via a diagnostic message to a gateway connected to the head unit system, enabling the gateway to send the cooling request to the vehicle control unit and then enabling the vehicle control unit to control, based on pre-received temperature data, a cooling device to cool the intelligent driving domain controller, where the pre-received temperature data is sent by the intelligent driving domain controller using an application message before the vehicle enters a silent state.

A eighth aspect of the present application provides an electronic device, including a memory, a processor, and a computer program stored in the memory and executable by the processor. The processor is configured to implement the method as described in the first aspect, the second aspect, or the third aspect when the computer program is executed.

A ninth aspect of the application provides a vehicle, including a thermal management system of the vehicle as described in the fourth aspect or an electronic device as described in the eighth aspect.

In view of above, according to the thermal management methods, system, apparatus, electronic device, and vehicle for a vehicle provided by the present application, the method includes: controlling, by the vehicle control unit, the cooling device to cool the intelligent driving domain controller based on pre-received temperature data when receiving a cooling request. This prevents the intelligent driving domain controller from overheating and compromising its operational performance, which would subsequently affect intelligent driving functions of the vehicle. The temperature data is sent by the intelligent driving domain controller via the application message before the vehicle entering the silent state. When the vehicle is in the silent state and the controller area network bus of the vehicle does not include the private controller area network bus, the vehicle cannot send the application message. Therefore, by sending the temperature data before the vehicle enters the silent state, it can be ensured that the vehicle control unit can determine a cooling strategy for the intelligent driving domain controller based on the temperature data even after the vehicle has entered the silent state, thereby meeting a cooling requirement during the upgrade of the intelligent driving domain controller via over-the-air technology. The cooling request is sent by the head unit system during the upgrade of the intelligent driving domain controller via over-the-air technology, to request the vehicle control unit to cool the intelligent driving domain controller. Furthermore, the thermal management method for the vehicle provided by the present application achieves cooling for the intelligent driving domain controller without a need to install a private controller area network bus, thereby meeting the cooling requirement of the intelligent driving domain controller while reducing a cost associated with installing the private controller area network bus.

### BRIEF DESCRIPTION OF THE DRAWINGS

FIG. 1 is a schematic structural diagram of internal communication connections of a vehicle according to an embodiment of the present application.
FIG. 2 is a schematic structural diagram of internal communication connections of a vehicle according to another embodiment of the present application.
FIG. 3 is a schematic flowchart of a thermal management method for a vehicle according to an embodiment of the present application.
FIG. 4 is a schematic flowchart of a thermal management method for a vehicle according to another embodiment of the present application.
FIG. 5 is a schematic structural diagram of a thermal management system for a vehicle according to an embodiment of the present application.
FIG. 6 is a schematic structural diagram of a thermal management device for a vehicle according to an embodiment of the present application.
FIG. 7 is a schematic structural diagram of a thermal management device for a vehicle according to another embodiment of the present application.
FIG. 8 is a schematic structural diagram of a thermal management device for a vehicle according to another embodiment of the present application.
FIG. 9 is a schematic structural diagram of a hardware structure of an electronic device according to the present application.

### DETAILED DESCRIPTION OF THE EMBODIMENTS

As described in the background, to meet the current development requirements of the driving automation system, especially for a driving automation system at L3 of Autonomous Driving Classification (such as, SAE) and above, robust algorithms, substantial computing power, and vast data support are required. The automotive artificial intelligence (AI) chip that provide computing power face extremely high requirements. For Intelligent Driving Domain Controllers (intelligent driving domain controllers) that integrate a plurality of Systems-On-Chip (SoCs), computing power has increased from several tens of Tera Operations Per Second (TOPS) to hundreds, or even thousands, of TOPS. The increase in computing power, combined with a compact layout of a vehicle, means that natural heat dissipation and air cooling are no longer sufficient to meet thermal dissipation requirements of the domain controller. Liquid cooling has thus become an inevitable choice.

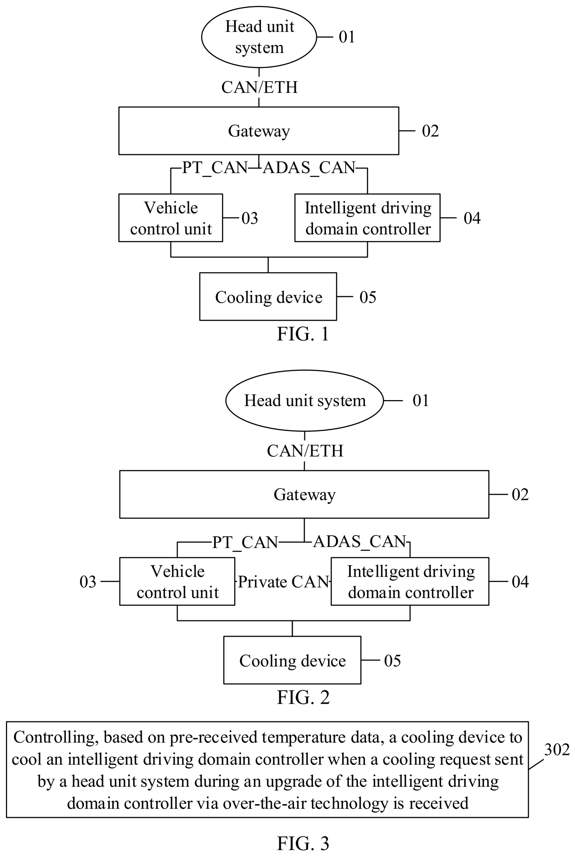

FIG. 1 shows a schematic structural diagram of internal communication connections of a vehicle. A head unit system (HUT) 01, a gateway (GW) 02, a vehicle control unit (VCU) 03, and an intelligent driving domain controller (IDC) 04 are connected through controller area network (CAN) bus. As shown in FIG. 1, the head unit system 01 and the gateway 02 are connected through the CAN bus and Ethernet (ETH). The gateway 02 and the intelligent driving domain controller 04 are connected through controller area network for an Advanced Driver Assistance System (ADAS _CAN). The gateway 02 and the vehicle control unit 03 are connected through power train controller area network (PT_CAN). No private controller area network bus is arranged between the vehicle control unit 03 and the intelligent driving domain controller 04. When the intelligent driving domain controller operates normally and requires heat dissipation, the intelligent driving domain controller 04 sends a cooling request to the gateway 02 through the ADAS_CAN. The gateway 02 then sends the cooling request to the head unit system 01 through the CAN. After determining a cooling strategy, the head unit system 01 sends the cooling request to the vehicle control unit 03 by the gateway 02 via the PT_CAN. The vehicle control unit 03 then controls the cooling device 05 to cool the intelligent driving domain controller 04 based on the cooling strategy. The cooling request and the cooling strategy are sent via the application messages. During the upgrade of the intelligent driving domain controller 04 via the over-the-air technology, since the vehicle is in a silent state at this time and the CAN bus (including the ADAS_CAN and the PT_CAN) is also in a silent state, the application messages cannot be transmitted via the CAN bus. Thus, the intelligent driving domain controller 04 may not send the cooling request to the vehicle control unit 03 to enable the cooling device 05 to cool and dissipate heat for the intelligent driving domain controller 04.

FIG. 2 shows another schematic structural diagram of internal communication connections of a vehicle. A head unit system (HUT) 01, a gateway (GW) 02, a vehicle control unit (VCU) 03, and an intelligent driving domain controller (IDC) 04 are connected through controller area network (CAN) bus. Compared with FIG. 1, a private controller area network bus is arranged between the vehicle control unit 03 and the intelligent driving domain controller 04 in FIG. 2. When the vehicle is in a silent state, the private controller area network bus remains active, allowing the intelligent driving domain controller 04 to send a cooling request to the vehicle control unit 03 through the private controller area network bus to meet a heat dissipation requirement during an upgrade. However, based on FIG. 1, installation of an additional private controller area network bus would significantly increase communication costs. Therefore, there is an urgent need for a low-cost cooling method meeting the cooling requirement of the intelligent driving domain controller 04 during its upgrade process. In view of this, the present application provides a thermal management method for a vehicle. Based on the structure of the internal communication connections of the vehicle shown in FIG. 1, cooling of the intelligent driving domain controller is realized to ensure that the intelligent driving domain controller may operate normally.

The embodiments of the present application will be described in detail with reference to the accompanying drawings in the following.

The present application provides a thermal management method for a vehicle, applied to a vehicle control unit. A controller area network bus of the vehicle does not include a private controller area network bus. As shown in FIG. 3, the method includes the following step.

Step 302: controlling, based on pre-received temperature data, a cooling device to cool an intelligent driving domain controller when a cooling request sent by a head unit system during an upgrade of the intelligent driving domain controller via over-the-air technology is receivedlogy is received. The temperature data is sent by the intelligent driving domain controller via an application message before the vehicle enters a silent state.

Specifically, when the vehicle needs to be upgraded, a cloud-side will deliver components requiring upgrades and necessary upgrade files to the head unit system. The head unit system then sends upgrade instructions to each component requiring the upgrade. When the intelligent driving domain controller needs to be upgraded, the head unit system sends the upgrade instruction to the intelligent driving domain controller, and the intelligent driving domain controller begins to be upgraded. Generally, since an upgrade software package for the intelligent driving domain controller is large, an upgrade process for the intelligent driving domain controller is defined within the scope of high-voltage Firmware Over-The-Air (Fover-the-air technology) components. In this case, a high-voltage system of the vehicle is active, and internal chips of the intelligent driving domain controller are operating normally, with power consumption remaining at a normal level. External components connected to the intelligent driving domain controller, such as cameras and LiDARs, are powered on, resulting in a relatively high overall power consumption for the intelligent driving domain controller. Consequently, it is necessary to cool the intelligent driving domain controller to meet its heat dissipation requirements and ensure its normal operation. This embodiment is implemented based on the structure of the internal vehicle communication connections shown in FIG. 1, where the CAN bus of the vehicle does not include the private CAN bus. In this case, the vehicle enters a silent state, during which application messages cannot be sent via a local area network of the vehicle, and only diagnostic messages can be transmitted. The head unit system 01 sends the diagnostic message as the cooling request to the vehicle control unit 03, serving as a flag to initiate cooling. This enables cooling for the intelligent driving domain controller 04 during its over-the-air technology process, ensuring the heat dissipation requirement are met, and maintaining a normal operating state. Exemplarily, the diagnostic message may be: DoIP: 31 01 02 17 01.

After receiving the cooling request, the vehicle control unit 03 is configured to determine whether the cooling device 05 has faults. If no fault is detected, the vehicle control unit 03 feeds back a no-fault signal. Exemplarily, the no-fault signal may be: DoCAN: 71 01 02 17 00. Meanwhile, the vehicle control unit 03 is configured to determine a cooling strategy based on received temperature data, for example, output power or an opening degree of the cooling device 05; and control the cooling device 05 to cool the intelligent driving domain controller 04 based on the cooling strategy. It should be noted that the temperature data is obtained in real time by the intelligent driving domain controller 04 through a temperature sensor in advance. Before the intelligent driving domain controller enters the upgrade process, the temperature data is sent to the vehicle control unit 03 in a form of an application message through the CAN bus. During normal operation, the intelligent driving domain controller 04 periodically sends the temperature data to the vehicle control unit 03 via the CAN bus. The temperature data may include a current temperature of the intelligent driving domain controller 04 itself, a temperature of the cooling device, etc., enabling the vehicle control unit 03 to determine a real-time cooling strategy based on real-time temperature data to cool the intelligent driving domain controller 04. Since the vehicle enters a silent state after the intelligent driving domain controller 04 begins the upgrade process, the application messages may not be transmitted. Therefore, in this embodiment, during the upgrade of the intelligent driving domain controller 04, the temperature data received by the vehicle control unit 03 in the last time before the upgrade may be used as the basis for determining the cooling strategy during the upgrade, to formulate the cooling strategy that meets the heat dissipation requirements of the intelligent driving domain controller 04 during the upgrade process.

According to the step 302 mentioned above, the thermal management method for the vehicle provided by this embodiment includes: controlling, by the vehicle control unit, the cooling device to cool the intelligent driving domain controller based on pre-received temperature data when receiving a cooling request. This prevents the intelligent driving domain controller from overheating and compromising its operational performance, which would subsequently affect intelligent driving functions of the vehicle. The temperature data is sent by the intelligent driving domain controller via the application message before the vehicle entering the silent state. When the vehicle is in the silent state and the controller area network bus of the vehicle does not include the private controller area network bus, the vehicle cannot send the application message. Therefore, by sending the temperature data before the vehicle enters the silent state, it can be ensured that the vehicle control unit can determine a cooling strategy for the intelligent driving domain controller based on the temperature data even after the vehicle has entered the silent state, thereby meeting a cooling requirement during the upgrade of the intelligent driving domain controller via over-the-air technology. The cooling request is sent by the head unit system during the upgrade of the intelligent driving domain controller via over-the-air technology, to request the vehicle control unit to cool the intelligent driving domain controller. Furthermore, the thermal management method for the vehicle provided by the present application achieves cooling for the intelligent driving domain controller without a need to install a private controller area network bus, thereby meeting the cooling requirement of the intelligent driving domain controller while reducing a cost associated with installing the private controller area network bus.

In some embodiments, the temperature data includes a current temperature of the intelligent driving domain controller and an inlet temperature of a cooling loop for cooling the intelligent driving domain controller; and the cooling device includes a fan and a water pump of the cooling loop; the step of controlling, based on pre-received temperature data, a cooling device to cool the intelligent driving domain controller includes: determining, based on the current temperature and the inlet temperature of the cooling loop, an opening degree of the fan and an opening degree of the water pump according to a pre-established calibration table, where the calibration table is used to characterize a correspondence relationship between the current temperature, the inlet temperature of the cooling loop, the opening degree of the fan, and the opening degree of the water pump; and controlling, based on the opening degree of the water pump and the opening degree of the fan, the water pump and the fan to cool the intelligent driving domain controller, respectively.

Specifically, a calibration table is pre-established, and the calibration table is used to characterize a correspondence relationship between the current temperature, the inlet temperature of the cooling loop, the opening degree of the fan, and the opening degree of the water pump, as shown in Table 1. The temperature data includes a temperature of the intelligent driving domain controller (IDC temperature) and the inlet temperature of the cooling loop. The temperature of the intelligent driving domain controller refers to a maximum temperature of chips within the intelligent driving domain controller. Once the temperature of the intelligent driving domain controller and the inlet temperature of the cooling loop are determined, a unique opening degree of the fan and a unique opening degree of the water pump are determined. The opening degree of the fan and the opening degree of the water pump are derived through linear fitting. If the inlet temperature is less than 40°C and greater than 20°C, and the temperature of the intelligent driving domain controller is less than 50°C and greater than 30°C, the higher value is selected to determine the corresponding opening degree of the water pump at 30% and the corresponding opening degree of the fan at 20%, ensuring that the heat dissipation requirements of the intelligent driving domain controller are met. After determining the opening degree of the water pump and the opening degree of the fan, the vehicle control unit controls the operation of the water pump based on the opening degree of the water pump and controls the operation of the fan based on the opening degree of the fan to cool the intelligent driving domain controller. By using the calibration table to look up and determine the opening degree of the water pump and the opening degree of the fan, the cooling strategy can be quickly determined, thereby enabling rapid cooling of the intelligent driving domain controller and improving cooling efficiency.

**Table 1 Calibration table**

| Inlet temperature | IDC temperature | Opening degree of water pump (%) | Opening degree of fan (%) |
|---|---|---|---|
| 20 | 30 | 15 | 15 |
| 40 | 50 | 30 | 20 |
| 60 | 70 | 40 | 30 |
| 70 | 85 | 60 | 50 |
| 80 | 100 | 95 | 70 |

In some embodiments, the method further includes: controlling the cooling device to stop cooling the intelligent driving domain controller when a cooling end request is not received within a first preset duration, where the cooling end request is forwarded by the head unit system using a diagnostic message via a gateway connected to the head unit system after the upgrade of the intelligent driving domain controller is completed.

Specifically, when the upgrade of the intelligent driving domain controller is completed, cooling of the intelligent driving domain controller may be stopped to reduce power consumption of the cooling device. In this case, the head unit system sends a DoIP command in the form of the diagnostic message as the cooling end request to the gateway directly connected to the head unit system. Exemplarily, the cooling end request may be: DoIP:31 01 02 17 02. The gateway forwards the cooling end request to the vehicle control unit. After receiving the cooling end request, if the cooling process is successfully ended, the vehicle control unit sends a cooling success feedback signal to the gateway. The cooling success feedback signal may be, for example, DoCAN: 71 01 02 17 00. If the vehicle control unit confirms that the cooling termination has failed, it feeds back a cooling request failure signal to the gateway. The cooling request failure signal may be DoCAN: 71 01 02 17 01. If the gateway receives the cooling request failure signal or does not receive any feedback signal from the vehicle control unit for a preset duration (for example, 3s), the head unit system may resend the cooling end request. Regardless of whether the cooling end request is successful, the head unit system may send a feedback signal to an Over-the-Air Technology client (OTA Client) based on an actual upgrade result of the intelligent driving domain controller. The feedback signal may be an upgrade success signal or an upgrade failure signal. Furthermore, if an upgrade duration of the intelligent driving domain controller exceeds a second preset duration, and the vehicle control unit has not received the cooling end request, the vehicle control unit will directly control the cooling device to stop cooling the intelligent driving domain controller. Exemplarily, the second preset duration may be set to 1 hour. The second preset duration is predetermined based on an actual upgrade process. Generally, the intelligent driving domain controller may complete the upgrade within the second preset duration. After the upgrade duration of the intelligent driving domain controller exceeds the second preset duration, the vehicle control unit controls the cooling device to stop operation in order to reduce unnecessary energy consumption.

The present application provides a thermal management method for a vehicle, applied to an intelligent driving domain controller, where a controller area network bus of the vehicle does not include a private controller area network bus; and the method includes: sending temperature data to a vehicle control unit via an application message before the vehicle enters a silent state, enabling the vehicle control unit to control, based on the temperature data, a cooling device to cool the intelligent driving domain controller upon receiving a cooling request, where the cooling request is generated and sent by a head unit system during an upgrade of the intelligent driving domain controller via over-the-air technology.

Specifically, the temperature data is obtained in real time by the intelligent driving domain controller in advance. Before the intelligent driving domain controller enters the upgrade process, the temperature data is sent to the vehicle control unit in a form of an application message via the CAN bus. During normal operation, the intelligent driving domain controller periodically sends the temperature data to the vehicle control unit via the CAN bus. The temperature data may include a current temperature of the intelligent driving domain controller itself, a temperature of the cooling device, etc., enabling the vehicle control unit to determine a real-time cooling strategy based on real-time temperature data to cool the intelligent driving domain controller. Since the vehicle enters a silent state after the intelligent driving domain controller begins the upgrade process, the application messages may not be transmitted. Therefore, in this embodiment, during the upgrade process of the intelligent driving domain controller, the temperature data received by the vehicle control unit in the last time before the upgrade may be used as the basis for determining the cooling strategy during the upgrade, so that the vehicle control unit can formulate the cooling strategy that meets the heat dissipation requirements of the intelligent driving domain controller during the upgrade process. Meanwhile, the head unit system will send a diagnostic message as the cooling request to the vehicle control unit to serve as a flag for initiating cooling. Exemplarily, the diagnostic message may be DoIP: 31 01 02 17 01. The vehicle control unit controls the cooling device to cool the intelligent driving domain controller based on the received cooling request and the received temperature data.

In conventional art, when the vehicle is upgraded via the over-the-air technology, during upgrades of components of the vehicle other than the intelligent driving domain controller, the intelligent driving domain controller remains in a normal power consumption state and thus requires continuous cooling. When the cooling device cools the intelligent driving domain controller, it also consumes a certain amount of electrical power, thereby consequently affecting a driving range of the electric vehicle. To reduce unnecessary energy consumption during this process, the present application provides a method for optimizing the energy consumption generated by the intelligent driving domain controller during the upgrade of other components.

In some embodiments, the method further includes: canceling creation of an intelligent driving process when components of the vehicle other than the intelligent driving domain controller are upgraded via the over-the-air technology.

Specifically, during the upgrade process of the vehicle, if the intelligent driving domain controller does not require an upgrade, then it enters a low-power mode. Specifically, the low-power mode involves shutting down all camera devices and LiDARs connected to the intelligent driving domain controller. Meanwhile, processes related to intelligent driving functions are no longer created. In this case, only diagnostic services of normal underlying software are kept operational. Under these conditions, due to the low power consumption of the intelligent driving domain controller, there is no heat dissipation requirement. This embodiment not only reduces the power consumption of the intelligent driving domain controller itself but also minimizes the power consumption of the cooling device, further decreasing the electrical energy consumption in the electric vehicle. The saved electrical energy may then be utilized to power the vehicle, increasing the driving range and enhancing an endurance capability. After the vehicle upgrade is completed, the high-voltage system of the vehicle is reactivated, the intelligent driving domain controller exits the low-power mode, correspondingly powers on the connected camera devices and the LiDARs, and re-establishes processes related to intelligent driving functions.

During normal driving of the vehicle, overheating may occur. It is necessary to formulate a corresponding overheating protection strategy to cool the intelligent driving domain controller, thereby ensuring its normal operation. The overheating protection strategy for the intelligent driving domain controller provided by the present application will be described in an embodiment in the following.

In some embodiments, the method further includes: controlling a system-on-chip of the intelligent driving domain controller to shut down via a micro-controller unit when an Advanced Driver-Assistance System (ADAS) function is activated, and a temperature of the intelligent driving domain controller exceeds a preset temperature threshold for a preset period and remains above the preset temperature threshold for a third preset duration; controlling the system-on-chip of the intelligent driving domain controller to shut down via the micro-controller unit when the ADAS function is not activated, and the temperature of the intelligent driving domain controller exceeds the preset temperature threshold for the preset period.

Specifically, a normal driving process of the vehicle may be classified into two scenarios. In a first scenario, when the ADAS function is activated and the temperature of the intelligent driving domain controller exceeds a preset temperature threshold for a preset period, it indicates that the intelligent driving domain controller is overheating and requires emergency heat dissipation measures. The intelligent driving domain controller then sends a warning message to an instrument panel. Exemplarily, if the temperature of the intelligent driving domain controller exceeds 105°C across 10 consecutive monitoring cycles, it is determined that the intelligent driving domain controller is experiencing an over-temperature condition, necessitating emergency heat dissipation. To ensure the driver notices the warning message, the warning message may be sent repeatedly and frequently. After the warning message is sent, if a third preset duration is reached, a Micro-Controller Unit (MCU) of the vehicle then shuts down the System-on-Chip (SOC) of the intelligent driving domain controller. Exemplarily, the third preset duration may be set to 20s. Since the ADAS function is active, within the third preset duration, the vehicle may perform relevant emergency operations, such as pulling over to the side of the road or slowing down, to ensure driving safety. After the SoC is shut down, functions related to intelligent driving are deactivated. The power consumption of the intelligent driving domain controller is significantly reduced, thus decreasing the heat generated and achieving emergency heat dissipation for the intelligent driving domain controller. In a second scenario, when the ADAS function is not activated, the MCU may directly shut down the SoC without waiting for the third preset duration. Simultaneously, the warning message is sent to the instrument panel to alert the driver of the overheating condition, so that timely action can be taken. After the overheating occurs, the ADAS function may not be reactivated in a current power-on cycle of the vehicle. If a driver attempts to activate the ADAS function, the driver will be notified that the system is unavailable due to overheating, thereby ensuring driving safety.

In some embodiments, the method further includes: acquiring a temperature of the intelligent driving domain controller in real time, and determining a required coolant flow rate for the cooling device after the upgrade of the intelligent driving domain controller via the over-the-air technology is completed; and sending the temperature of the intelligent driving domain controller and the coolant flow rate to the vehicle control unit in real time via the application message, enabling the vehicle control unit to cool, based on the temperature of the intelligent driving domain controller and the required coolant flow rate, the intelligent driving domain controller.

Specifically, after the upgrade of the intelligent driving domain controller is completed, the vehicle exits the silent mode and enters a normal mode. At this point, the intelligent driving domain controller acquires the current temperature of its own in real time and calculates the required coolant flow rate in the cooling loop based on the current temperature. Subsequently, the current temperature and the coolant flow rate are sent to the vehicle control unit in real time via the application message, so that the vehicle control unit may determine a real-time cooling strategy based on the current temperature and the coolant flow rate to cool the intelligent driving domain controller. As shown in FIG. 1, a transmission path of the application message in this phase is: IDC04 → ADAS_CAN → GW02 → PT_CAN → VCU03.

The present application further provides a thermal management method for a vehicle, applied to a head unit system, where a controller area network bus of the vehicle does not include a private controller area network bus; and the method includes: generating a cooling request during an upgrade of an intelligent driving domain controller via over-the-air technology; and sending the cooling request via a diagnostic message to a gateway connected to the head unit system, enabling the gateway to send the cooling request to the vehicle control unit and then enabling the vehicle control unit to control, based on pre-received temperature data, a cooling device to cool the intelligent driving domain controller, where the temperature data is sent by the intelligent driving domain controller using an application message before the vehicle enters a silent state.

Specifically, this embodiment is implemented based on the structural diagram of the internal vehicle communication connections shown in FIG. 1, where the controller area network bus of the vehicle does not include the private controller area network bus. At this point, the intelligent driving domain controller is upgraded via the over-the-air technology. In this case, the vehicle enters a silent state, during which application messages cannot be sent via a local area network of the vehicle, and only diagnostic messages can be transmitted. The head unit system 01 sends the diagnostic message as the cooling request to the vehicle control unit 03, serving as a flag to initiate cooling. This enables cooling for the intelligent driving domain controller 04 during its over-the-air technology process, ensuring the heat dissipation requirement are met, and maintaining a normal operating state. Exemplarily, the diagnostic message may be: DoIP: 31 01 02 17 01.

Furthermore, the head unit system 01 sends a DoIP command as the cooling request to the gateway 02 directly connected to the head unit system 01. The DoIP command is an instruction based on Unified Diagnostic Services (UDS), implemented via Transmission Control Protocol/Internet Protocol (TCP/IP) and Ethernet (ETH). The gateway 02 then forwards this DoIP command to the vehicle control unit 03, serving as a flag to initiate cooling. After receiving the cooling request, the vehicle control unit 03 determines whether the cooling device 05 has faults. If no fault is detected, the vehicle control unit 03 feeds back a no-fault signal to the gateway 02. For example, the no-fault signal may be DoCAN: 71 01 02 17 00. Exemplarily, the cooling device 05 may include a water pump of the cooling loop and a fan. The cooling loop provides liquid cooling for the intelligent driving domain controller 04, while the fan provides air cooling for the intelligent driving domain controller 04. It should be noted that the cooling loop in this embodiment may be a motor cooling loop, a battery cooling loop, or a cooling loop of other components in the vehicle. Among cooling loops arranged in the vehicle, a cooling loop adjacent to the intelligent driving domain controller may serve as the cooling loop used for cooling the intelligent driving domain controller. In this embodiment, there are no specific limitations on the components of the cooling loop.

In some embodiments, the method further includes: resending the cooling request to the vehicle control unit when the gateway receives a cooling failure signal or fails to receive a feedback signal from the vehicle control unit for a fourth preset duration; where the cooling failure signal is sent by the vehicle control unit to the gateway when cooling of the intelligent driving domain controller fails; and terminating the upgrade of the intelligent driving domain controller after resending the cooling request to the vehicle control unit and the cooling of the intelligent driving domain controller fails.

Specifically, if the vehicle control unit determines that the cooling has failed, it feeds back a cooling failure signal to the gateway, for example, DoCAN:71 01 02 17 01. If the gateway receives the cooling failure signal or does not receive a feedback signal from the vehicle control unit for the fourth preset duration, then the head unit system resends the cooling request to the vehicle control unit, thereby enabling the vehicle control unit to control the cooling device to cool the intelligent driving domain controller. Exemplarily, the fourth preset duration may be set to 3s. If cooling fails again, the head unit system terminates the current upgrade process of the intelligent driving domain controller and sends an upgrade failure signal to an over-the-air technology Client (OTA Client), so as to prevent the upgrade from proceeding under cooling failure conditions and avoid overheating of the intelligent driving domain controller. If cooling is successful, the upgrade process of the intelligent driving domain controller continues.

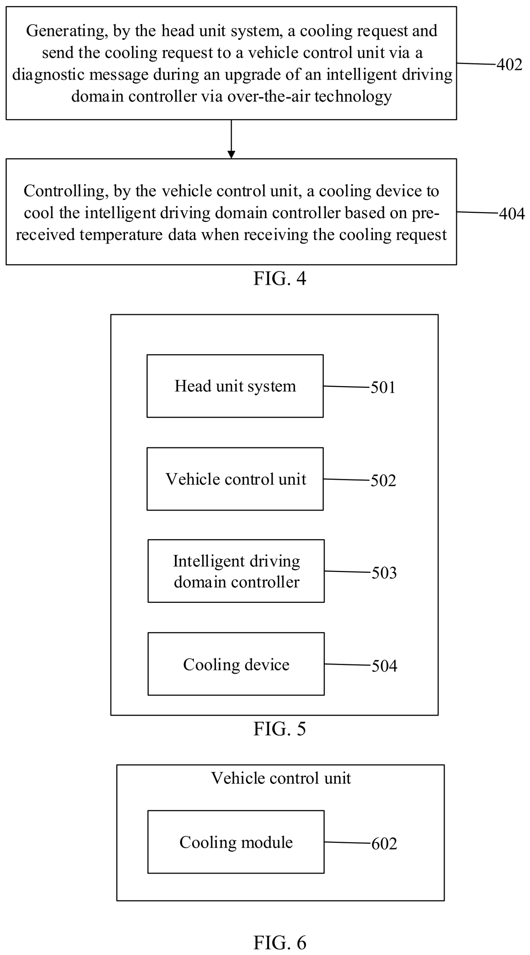

The present application further provides a thermal management method for a vehicle, where a controller area network bus of the vehicle does not include a private sensor area network bus. Referring to FIG. 4, the method specifically includes the following steps.

Step 402: generating, by the head unit system, a cooling request and send the cooling request to a vehicle control unit via a diagnostic message during an upgrade of an intelligent driving domain controller via over-the-air technology.

Step 404: controlling, by the vehicle control unit, a cooling device to cool the intelligent driving domain controller based on pre-received temperature data when receiving the cooling request, where the temperature data is sent by the intelligent driving domain controller to the vehicle control unit using an application message before the vehicle enters a silent state.

Based on the steps 402 to 404 mentioned above, when the intelligent driving domain controller is upgraded via the over-the-air technology, the vehicle is in the silent state. At this point. the head unit system generates the cooling request and sends the cooling request to the vehicle control unit via the diagnostic message, so that the vehicle control unit may receive the cooling request while the vehicle is in the silent state, thereby making it possible to achieve cooling of the intelligent driving domain controller. The vehicle control unit controls the cooling device to appropriately cool the intelligent driving domain controller based on the received cooling request and the received temperature data, thereby preventing the vehicle control unit from overheating and affecting its operational performance and further impacting the intelligent driving functions of the vehicle. The temperature data is sent by the intelligent driving domain controller to the vehicle control unit via the application message before the vehicle enters the silent state, thereby avoiding the situation where temperature datCANnot be received after the vehicle enters the silent state. Furthermore, the thermal management method for the vehicle provided by this embodiment achieves cooling of the intelligent driving domain controller during the upgrade of the intelligent driving domain controller without a need to install a private CAN bus, thereby meeting the cooling requirements of the intelligent driving domain controller while reducing a cost associated with installation of the private CAN bus.

It should be noted that the method according to embodiments of the present application may be executed by a single device, such as a computer or a server. Alternatively, the method of this embodiment may also be applied in a distributed scenario, where it is executed by multiple devices working in coordination. In such a distributed scenario, one of these devices may execute only one or more specific steps of the method according to embodiments of the present application, and these devices interact with each other to implement the method.

It should be noted that some of the embodiments of the present application are described above. Other embodiments are within the scope of the appended claims. In some cases, actions or steps described in claims of the present disclosure can be carried out in a different order than that in the above-mentioned embodiments and still achieve the desired results. Furthermore, the processes depicted in the accompanying drawings do not necessarily require the specific or sequential order shown to achieve the desired outcome. In some implementations, multitasking and parallel processing are also possible or may be beneficial.

Based on a same inventive concept, corresponding to any of the above-mentioned embodiments, the present application further provides a thermal management system for a vehicle.

Referring to FIG. 5, in the thermal management system for the vehicle, a controller area network bus of the vehicle does not include a private controller area network bus; and the system includes a head unit system 501, a vehicle control unit 502, an intelligent driving domain controller 503, and a cooling device 504.

The head unit system 501 is configured to generate a cooling request and send the cooling request to the vehicle control unit 502 via a diagnostic message during an upgrade of the intelligent driving domain controller 503.

The vehicle control unit 502 is configured to control a cooling device to cool, based on pre-received temperature data, the intelligent driving domain controller 503 when receiving the cooling request.

The intelligent driving domain controller 503 is configured to send temperature data to the vehicle control unit 502 via an application message before the vehicle enters a silent state.

The cooling device 504 is configured to cool the intelligent driving domain controller 503.

In some embodiment, the temperature data includes a current temperature of the intelligent driving domain controller and an inlet temperature of a cooling loop for cooling the intelligent driving domain controller; and the cooling device includes a fan and a water pump of the cooling loop. The vehicle control unit 502 is further configured to determine, based on the current temperature and the inlet temperature of the cooling loop, an opening degree of the fan and an opening degree of the water pump according to a pre-established calibration table, where the calibration table is used to characterize a correspondence relationship between the current temperature, the inlet temperature of the cooling loop, the opening degree of the fan, and the opening degree of the water pump; and control, based on the opening degree of the water pump and the opening degree of the fan, the water pump and the fan to cool the intelligent driving domain controller, respectively.

In some embodiments, the vehicle control unit 502 is further configured to control the cooling device to stop cooling the intelligent driving domain controller when a cooling end request is not received within a first preset duration, where the cooling end request is forwarded by the head unit system using a diagnostic message via a gateway connected to the head unit system after the upgrade of the intelligent driving domain controller is completed.

In some embodiments, the intelligent driving domain controller 503 is further configured to send temperature data to a vehicle control unit via an application message before the vehicle enters a silent state, enabling the vehicle control unit to control, based on the temperature data, a cooling device to cool the intelligent driving domain controller upon receiving a cooling request, where the cooling request is generated and sent by a head unit system during an upgrade of the intelligent driving domain controller via over-the-air technology.

In some embodiments, the intelligent driving domain controller 503 is further configured to cancel creation of an intelligent driving process when components of the vehicle other than the intelligent driving domain controller are upgraded via the over-the-air technology.

In some embodiments, the system further includes a micro-controller unit (MCU), and the MCU is further configured to control a system-on-chip of the intelligent driving domain controller to shut down via a micro-controller unit when an Advanced Driver-Assistance System function is activated, and a temperature of the intelligent driving domain controller exceeds a preset temperature threshold for a preset period and remains above the preset temperature threshold for a third preset duration; control the system-on-chip of the intelligent driving domain controller to shut down via the micro-controller unit when the Advanced Driver-Assistance System function is not activated, and the temperature of the intelligent driving domain controller exceeds the preset temperature threshold for the preset period.

In some embodiments, the head unit system 501 is further configured to generate a cooling request during an upgrade of an intelligent driving domain controller via over-the-air technology; and send the cooling request via a diagnostic message to a gateway connected to the head unit system, enabling the gateway to send the cooling request to the vehicle control unit and then enabling the vehicle control unit to control, based on pre-received temperature data, a cooling device to cool the intelligent driving domain controller, wherein the temperature data is sent by the intelligent driving domain controller using an application message before the vehicle enters a silent state.

In some embodiments, the head unit system 501 is configured to resend the cooling request to the vehicle control unit when the gateway receives a cooling failure signal or fails to receive a feedback signal from the vehicle control unit for a fourth preset duration; wherein the cooling failure signal is sent by the vehicle control unit to the gateway when cooling of the intelligent driving domain controller fails; and terminate the upgrade of the intelligent driving domain controller after resending the cooling request to the vehicle control unit and the cooling of the intelligent driving domain controller fails.

Based on the same inventive concept, corresponding to the method described in any of the above embodiments, the present application further provides thermal management apparatus for a vehicle. Referring to FIG. 6, the apparatus is applied to a vehicle control unit, where a controller area network bus of the vehicle does not include a private controller area network bus. The apparatus includes: a processor, where the processor is configured to execute a program module stored in a memory as follows: a cooling module 602, configured to control, based on pre-received temperature data, a cooling device to cool the intelligent driving domain controller when a cooling request sent by a head unit system during an upgrade of an intelligent driving domain controller via over-the-air technology is received, where the temperature data is sent by the intelligent driving domain controller via an application message before the vehicle enters a silent state.

In some embodiment, the temperature data includes a current temperature of the intelligent driving domain controller and an inlet temperature of a cooling loop for cooling the intelligent driving domain controller; and the cooling device includes a fan and a water pump of the cooling loop. The cooling module 602 is further configured to determine, based on the current temperature and the inlet temperature of the cooling loop, an opening degree of the fan and an opening degree of the water pump according to a pre-established calibration table, where the calibration table is used to characterize a correspondence relationship between the current temperature, the inlet temperature of the cooling loop, the opening degree of the fan, and the opening degree of the water pump; and control, based on the opening degree of the water pump and the opening degree of the fan, the water pump and the fan to cool the intelligent driving domain controller, respectively.

In some embodiments, the cooling module 602 is further configured to control the cooling device to stop cooling the intelligent driving domain controller when a cooling end request is not received within a first preset duration, where the cooling end request is forwarded by the head unit system using a diagnostic message via a gateway connected to the head unit system after the upgrade of the intelligent driving domain controller is completed.

In some embodiments, the cooling module 602 is further configured to control the cooling device to stop cooling the intelligent driving domain controller when the cooling end request is not received and an upgrade duration of the intelligent driving domain controller is greater than a second preset duration.

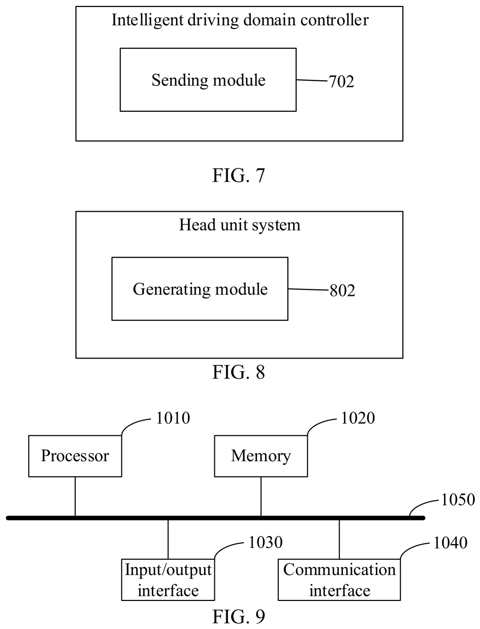

Based on the same inventive concept, corresponding to the method described in any of the above embodiments, the present application further provides thermal management apparatus for a vehicle. Referring to FIG. 7, the apparatus is applied to an intelligent driving domain controller, where a controller area network bus of the vehicle does not include a private controller area network bus; and the apparatus includes: a processor, where the processor is configured to execute a program module stored in a memory as follows: a sending module 702, configured to before the vehicle enters a silent state, send temperature data to a vehicle control unit via an application message before the vehicle enters a silent state, enabling the vehicle control unit to control, based on the temperature data, a cooling device to cool the intelligent driving domain controller upon receiving a cooling request, where the cooling request is generated and sent by a head unit system during an upgrade of the intelligent driving domain controller via over-the-air technology.

In some embodiments, the sending module 702 is further configured to cancel creation of an intelligent driving process when components of the vehicle other than the intelligent driving domain controller are upgraded via the over-the-air technology.

In some embodiments, the sending module 702 is further configured to control a system-on-chip of the intelligent driving domain controller to shut down via a micro-controller unit when an Advanced Driver-Assistance System function is activated, and a temperature of the intelligent driving domain controller exceeds a preset temperature threshold for a preset period and remains above the preset temperature threshold for a third preset duration; control the system-on-chip of the intelligent driving domain controller to shut down via the micro-controller unit when the Advanced Driver-Assistance System function is not activated, and the temperature of the intelligent driving domain controller exceeds the preset temperature threshold for the preset period.

Based on the same inventive concept, corresponding to the method described in any of the above embodiments, the present application further provides thermal management apparatus for a vehicle. Referring to FIG. 8, the apparatus is applied to a head unit system, where a controller area network bus of the vehicle does not include a private controller area network bus; and the device includes: a processor, where the processor is configured to execute a program module stored in a memory as follows: a generating module 802, configured to generate a cooling request during an upgrade of an intelligent driving domain controller via over-the-air technology; and send the cooling request via a diagnostic message to a gateway connected to the head unit system, enabling the gateway to send the cooling request to the vehicle control unit and then enabling the vehicle control unit to control, based on pre-received temperature data, a cooling device to cool the intelligent driving domain controller, wherein the temperature data is sent by the intelligent driving domain controller using an application message before the vehicle enters a silent state.

In some embodiments, the generating module 802 is further configured resend the cooling request to the vehicle control unit when the gateway receives a cooling failure signal or fails to receive a feedback signal from the vehicle control unit for a fourth preset duration; where the cooling failure signal is sent by the vehicle control unit to the gateway when cooling of the intelligent driving domain controller fails; and terminate the upgrade of the intelligent driving domain controller after resending the cooling request to the vehicle control unit and the cooling of the intelligent driving domain controller fails.

Based on the same inventive concept, corresponding to the method described in any of the above embodiments, the present application further provides an electronic device, including a memory, a processor, and a computer program stored in the memory and executable by the processor. The processor is configured to implement the thermal management method for the vehicle as described in any of the above embodiments when the program is executed.

FIG. 9 illustrates a more specific hardware structure diagram of the electronic device provided by this embodiment. The device may include a processor 1010, a memory 1020, an input/output interface 1030, a communication interface 1040, and a bus 1050. The processor 1010, the memory 1020, the input/output interface 1030, and the communication interface 1040 achieve internal communication connections within the device through the bus 1050.

The processor 1010 may be implemented using a general-purpose Central Processing Unit (CPU), a microprocessor, an Application Specific Integrated Circuit (ASIC), or one or more integrated circuits, for executing relevant programs to realize the technical solutions provided in the embodiments of the present application.

The memory 1020 may be implemented in the form of Read Only Memory (ROM), Random Access Memory (RAM), static storage devices, dynamic storage devices, or other forms. The memory 1020 may store an operating system and other application programs. When the technical solutions provided in the embodiments of the present application are implemented via software or firmware, relevant program codes are stored in the memory 1020 and invoked for execution by the processor 1010.

The input/output interface 1030 is used to connect input/output modules to achieve information input and output. The input/output module may be configured as components within the device (not shown in figures) or may be connected externally to the device to provide corresponding function. The input devices may include a keyboard, a mouse, a touchscreen, a microphone, various types of sensors, etc. The output devices may include a display, speakers, a vibrator, indicator lights, etc.

The communication interface 1040 is used to connect a communication module (not shown in figures), to enable communication interaction between this device and other devices. The communication module may achieve communication via wired means (such as USB, network cable, etc.) or wireless means (such as mobile network, WIFI, Bluetooth, etc.).

The bus 1050 includes a pathway for transmitting information between various components of the device (such as the processor 1010, the memory 1020, the input/output interface 1030, and the communication interface 1040).

It should be noted that, although only the processor 1010, the memory 1020, the input/output interface 1030, the communication interface 1040, and the bus 1050 are shown in the aforementioned device, in specific implementations, the device may also include other components necessary for normal operation. Moreover, it is understandable to those skilled in the art that the above-mentioned device may only include the components necessary for implementing the solutions of the embodiments of the present specification, and does not necessarily have to contain all the components shown in the figures.

The electronic device of the above-mentioned embodiments is used to implement the thermal management method for the vehicle corresponding to any of any of the above-mentioned embodiments, and possesses the beneficial effects of the corresponding method embodiments, which will not be reiterated here.

Based on the same inventive concept, corresponding to any of the above-mentioned embodiments, the present application further provides a vehicle including a thermal management system as described in any of the above-mentioned embodiments.

It is understandable that by those of ordinary skill in the art that the discussion of any of the above embodiments is merely exemplary and is not intended to imply that the scope of the present disclosure, including the claims, is limited to these examples. Within the framework of the present application, technical features of the above embodiments or different embodiments may also be combined, steps may be implemented in any order, and there exist many other variations in different aspects of the embodiments of the present application as described above, which are not provided in detail for the sake of brevity.

In addition, to simplify description and discussion, and to avoid making the embodiments of the present application difficult to understand, well-known power/ground connections to integrated circuit (IC) chips and other components may or may not be shown in the provided figures. Furthermore, the apparatus may be presented in block diagram form to avoid making the embodiments of the present application difficult to understand, and also in consideration of the fact that the details regarding the implementation of these block diagram devices are highly dependent on the platform on which the embodiments of the present application are to be implemented (i.e., these details should fall entirely within the understanding of those skilled in the art). When specific details (e.g., circuit) have been set forth to describe exemplary embodiments of the present application, it will be apparent to those skilled in the art that the embodiments of the present application may be implemented without these specific details or with variations thereof. Therefore, these descriptions should be considered illustrative rather than limiting.

Although the present application has been described in conjunction with specific embodiments thereof, many alternatives, modifications, and variations will be apparent to those of ordinary skill in the art in light of the foregoing description. For example, other memory architectures (e.g., Dynamic RAM (DRAM)) may utilize the embodiments discussed.

The embodiments of the present application are intended to cover all such alternatives, modifications, and variations that fall within the broad scope of the appended claims. Therefore, any omission, modification, equivalent replacement, improvement, etc., made within the spirit and principles of the embodiments of the present application shall be included within the protection scope of the present application.

## Claims

1. A thermal management method for a vehicle, applied to a vehicle control unit, wherein a controller area network bus of the vehicle does not comprise a private controller area network bus, and the method comprises:
controlling, based on pre-received temperature data, a cooling device to cool an intelligent driving domain controller when a cooling request sent by a head unit system during an upgrade of the intelligent driving domain controller via over-the-air technology is received, wherein the temperature data is sent by the intelligent driving domain controller via an application message before the vehicle enters a silent state.

2. The method according to claim 1, wherein the temperature data comprises a current temperature of the intelligent driving domain controller and an inlet temperature of a cooling loop for cooling the intelligent driving domain controller; the cooling device comprises a fan, and a water pump of the cooling loop; and
the controlling, based on pre-received temperature data, a cooling device to cool an intelligent driving domain controller, comprises:
determining, based on the current temperature and the inlet temperature of the cooling loop, an opening degree of the fan and an opening degree of the water pump according to a pre-established calibration table, wherein the calibration table is used to characterize a correspondence relationship between the current temperature, the inlet temperature of the cooling loop, the opening degree of the fan, and the opening degree of the water pump; and
controlling, based on the opening degree of the water pump and the opening degree of the fan, the water pump and the fan to cool the intelligent driving domain controller, respectively.

3. The method according to claim 1, further comprising:
controlling the cooling device to stop cooling the intelligent driving domain controller when a cooling end request is not received within a first preset duration, wherein the cooling end request is forwarded by the head unit system using a diagnostic message via a gateway connected to the head unit system after the upgrade of the intelligent driving domain controller is completed.

4. The method according to claim 3, further comprising:
controlling the cooling device to stop cooling the intelligent driving domain controller when the cooling end request is not received and an upgrade duration of the intelligent driving domain controller is greater than a second preset duration.

5. A thermal management method for a vehicle, applied to an intelligent driving domain controller, wherein a controller area network bus of the vehicle does not comprise a private controller area network bus; and the method comprises:
sending temperature data to a vehicle control unit via an application message before the vehicle enters a silent state, enabling the vehicle control unit to control, based on the temperature data, a cooling device to cool the intelligent driving domain controller upon receiving a cooling request, wherein the cooling request is generated and sent by a head unit system during an upgrade of the intelligent driving domain controller via over-the-air technology.

6. The method according to claim 5, further comprising:
canceling creation of an intelligent driving process when components of the vehicle other than the intelligent driving domain controller are upgraded via the over-the-air technology.

7. The method according to claim 5, further comprising:
controlling a system-on-chip of the intelligent driving domain controller to shut down via a micro-controller unit when an Advanced Driver-Assistance System function is activated, and a temperature of the intelligent driving domain controller exceeds a preset temperature threshold for a preset period and remains above the preset temperature threshold for a third preset duration;
controlling the system-on-chip of the intelligent driving domain controller to shut down via the micro-controller unit when the Advanced Driver-Assistance System function is not activated, and the temperature of the intelligent driving domain controller exceeds the preset temperature threshold for the preset period.

8. A thermal management method for a vehicle, applied to a head unit system, wherein a controller area network bus of the vehicle does not comprise a private controller area network bus; and the method comprises:
generating a cooling request during an upgrade of an intelligent driving domain controller via over-the-air technology; and
sending the cooling request via a diagnostic message to a gateway connected to the head unit system, enabling the gateway to send the cooling request to the vehicle control unit and then enabling the vehicle control unit to control, based on pre-received temperature data, a cooling device to cool the intelligent driving domain controller, wherein the temperature data is sent by the intelligent driving domain controller using an application message before the vehicle enters a silent state.

9. The method according to claim 8, further comprising:
resending the cooling request to the vehicle control unit when the gateway receives a cooling failure signal or fails to receive a feedback signal from the vehicle control unit for a fourth preset duration; wherein the cooling failure signal is sent by the vehicle control unit to the gateway when cooling of the intelligent driving domain controller fails; and
terminating the upgrade of the intelligent driving domain controller after resending the cooling request to the vehicle control unit and the cooling of the intelligent driving domain controller fails.

10. A thermal management system for a vehicle, wherein a controller area network bus of the vehicle does not comprise a private controller area network bus, and the system comprises a head unit system, a vehicle control unit, an intelligent driving domain controller, and a cooling device;
the head unit system is configured to generate a cooling request and send the cooling request to a vehicle control unit via a diagnostic message during an upgrade of an intelligent driving domain controller via over-the-air technology;
the vehicle control unit is configured to control a cooling device to cool, based on pre-received temperature data, the intelligent driving domain controller when receiving the cooling request;
the intelligent driving domain controller is configured to send temperature data to the vehicle control unit via an application message before the vehicle enters a silent state; and
the cooling device is configured to cool the intelligent driving domain controller.

11. A thermal management device for a vehicle applied to a vehicle control unit, wherein a controller area network bus of the vehicle does not comprise a private controller area network bus; and the device comprises: a processor, wherein the processor is configured to execute the following program module stored in a memory:
a cooling module, configured to control, based on pre-received temperature data, a cooling device to cool the intelligent driving domain controller when a cooling request sent by a head unit system during an upgrade of an intelligent driving domain controller via over-the-air technology is received, wherein the temperature data is sent by the intelligent driving domain controller via an application message before the vehicle enters a silent state.

12. A thermal management device for a vehicle applied to an intelligent driving domain controller, wherein a controller area network bus of the vehicle does not comprise a private controller area network bus; and the device comprises: a processor, wherein the processor is configured to execute the following program module stored in a memory:
a sending module, configured to send temperature data to a vehicle control unit via an application message before the vehicle enters a silent state, enabling the vehicle control unit to control, based on the temperature data, a cooling device to cool the intelligent driving domain controller upon receiving a cooling request, wherein the cooling request is generated and sent by a head unit system during an upgrade of the intelligent driving domain controller via over-the-air technology.

13. A thermal management device for a vehicle applied to a head unit system, wherein a controller area network bus of the vehicle does not comprise a private controller area network bus; and the device comprises: a processor, wherein the processor is configured to execute the following program modules stored in a memory:
a generating module, configured to generate a cooling request during an upgrade of an intelligent driving domain controller via over-the-air technology and send the cooling request via a diagnostic message to a gateway connected to the head unit system, enabling the gateway to send the cooling request to the vehicle control unit and then enabling the vehicle control unit to control, based on pre-received temperature data, a cooling device to cool the intelligent driving domain controller, wherein the pre-received temperature data is sent by the intelligent driving domain controller using an application message before the vehicle enters a silent state.

14. An electronic device, comprising a memory, a processor and a computer program stored in the memory and executable by the processor, wherein the processor is configured to implement the method according to any one of claims 1 to 8 when the computer program is executed.

15. A vehicle, comprising a thermal management system for the vehicle according to claim 10 or an electronic device according to claim 14.
